# EUROPÄISCHE PATENTSCHRIFT

(11) **EP 1 820 315 B1**
(45) Veröffentlichungstag und Bekanntmachung des Hinweises auf die Patenterteilung: **03.06.2009**
(21) Anmeldenummer: 05802260.9
(22) Anmeldetag: 08.10.2005
(51) Int. Cl.: H04L 27/36, H04B 1/04, H03F 1/02

(54) **Verfahren für die Ansteuerung eines EER-Leistungsverstärkers für digitale Übertragung**
Method for controlling an EER power amplifier for digital transmission
Procédé de contrôle d'un amplificateur de puissance pour la transmission numérique

(30) Priorität: 03.12.2004 DE 102004059088
(43) Veröffentlichungstag der Anmeldung: 22.08.2007
(73) Patentinhaber: Deutsche Telekom AG, 53113 Bonn (DE)
(72) Erfinder: SCHÄFER, Andreas, 15910 Bersteland (DE)
(74) Vertreter: Drosch, Ulrich
(86) Internationale Anmeldenummer: PCT/DE2005/001806
(87) Internationale Veröffentlichungsnummer: WO 2006/060975

(56) Entgegenhaltungen:
- MANN S ET AL: "INCREASING THE TALK-TIME OF MOBILE RADIOS WITH EFFICIENT LINEAR TRANSMITTER ARCHITECTURES" ELECTRONICS AND COMMUNICATION ENGINEERING JOURNAL, INSTITUTION OF ELECTRICAL ENGINEERS, LONDON, GB, Bd. 13, Nr. 2, April 2001 (2001-04), Seiten 65-76, XP001058796 ISSN: 0954-0695
- RAAB F H ET AL: "L-BAND TRANSMITTER USING KAHN EER TECHNIQUE" IEEE TRANSACTIONS ON MICROWAVE THEORY AND TECHNIQUES, IEEE SERVICE CENTER, PISCATAWAY, NJ, US, Bd. 46, Nr. 12, PART 2, Dezember 1998 (1998-12), Seiten 2220-2224, XP000805603 ISSN: 0018-9480

## Beschreibung

Die Erfindung betrifft das Gebiet der Leistungsverstärker zur Übertragung digitaler Signale, wie sie beispielsweise bei Rundfunksendern eingesetzt werden.

Die Leistungsverstärker arbeiten im Schaltbetrieb, wodurch im Vergleich zu linearen Verstärkern ein wesentlich höherer Wirkungsgrad erreicht wird. Die dadurch möglichen Einsparungen an Betriebskosten sind insbesondere bei Hochleistungssendern für den Rundfunk im Lang-, Mittel- und Kurzwellenbereich von enormer Bedeutung.

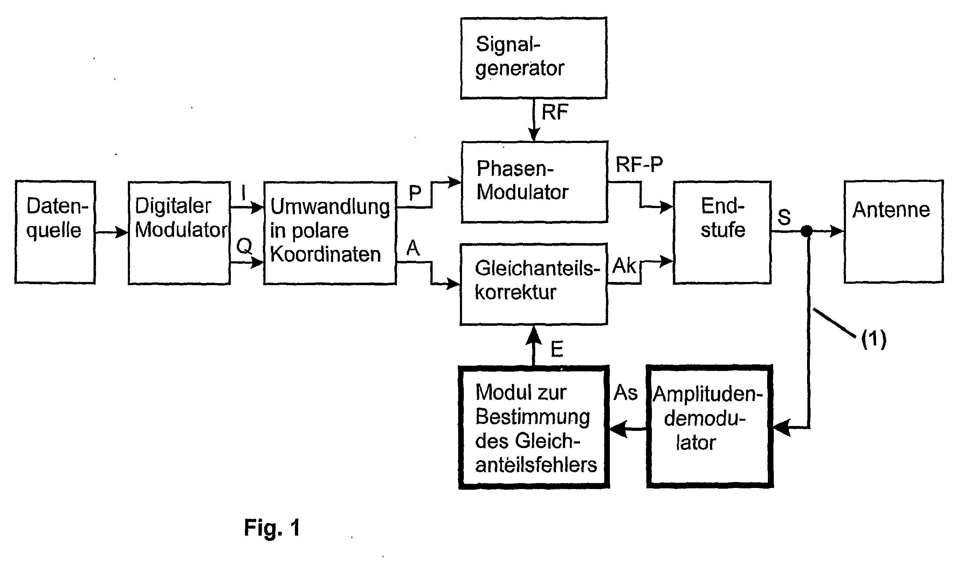

Für die Übertragung digitaler Modulationssignale wird bei den Leistungsverstärkern das bekannte Verfahren EER (Envelope Elimination and Restauration) angewendet. Dabei wird aus dem komplexen Modulationssignal durch Transformation eine Amplitudenkomponente und eine Phasenkomponente gebildet (Fig. 1). Mit der Phasenkomponente wird das Trägersignal RF (Radio Frequency) moduliert. In der Senderendstufe werden dann Amplitudensignal und phasenmoduliertes Trägersignal zum Sendesignal multiplikativ vereinigt [L. R. Kahn "Single sideband transmission by envelope elimination and restoration", Proc. IRE, vol. 40, no. 7, pp. 803-806, July 1952; MANN S ET AL: "INCREASING THE TALK-TIME OF MOBILE RADIOS WITH EFFICIENT LINEAR TRANSMITTER ARCHITECTURES" ELECTRONICS AND COMMUNICATION ENGINEERING JOURNAL, INSTITUTION OF ELECTRICAL ENGINEERS, LONDON, GB, Bd. 13, Nr. 2, April 2001 (2001-04), Seiten 65-76, XP001058796 ISSN: 0954-0695; RAAB F H ET AL: "L-BAND TRANSMITTER USING KAHN EER TECHNIQUE" IEEE TRANSACTIONS ON MICROWAVE THEORY AND TECHNIQUES, IEEE SERVICE CENTER, PISCATAWAY, NJ, US, Bd. 46, Nr. 12, PART 2, Dezember 1998 (1998-12), Seiten 2220-2224, XP000805603 ISSN: 0018-9480].

Das vom digitalen Modulator erzeugte komplexe Modulationssignal ist auf eine bestimmte Bandbreite begrenzt. Zur weiteren Verarbeitung im Verstärker wird das Modulationssignal, das in kartesischen Koordinaten mit Realteil und Imaginärteil bzw. Inphase- und Quadraturphasekomponente (I und Q) vorliegt, in polare Darstellung mit Amplitude und Phase transformiert. Bei diesem Prozess entstehen aus bandbegrenztem Real- und Imaginärteil das Amplitudensignal (A) und das Phasensignal (P) mit theoretisch unendlicher Bandbreite. Mit dem Phasensignal wird das Trägersignal RF moduliert. Beide Signalkomponenten, Amplitudensignal (A) und phasenmoduliertes Trägersignal (RF-P), müssen in den getrennten Verstärkerzweigen so verarbeitet werden, dass nach ihrer multiplikativen Zusammenführung in der Endstufe ein Sendesignal entsteht, das dem digitalen Modulationssignal entspricht und in der Bandbreite begrenzt ist. Die Anforderungen an den Verstärker in Bezug auf Linearität und Bandbreite sind extrem hoch. Jede kleine Verzerrung im Verstärker führt zu einer Abweichung des Sendesignals vom Modulationssignal und zu einem Anstieg der Randaussendungen. Das Sendesignal ist dann nicht mehr bandbegrenzt. Besonders kritisch ist das bei Verstärkern, die im Rundfunkbereich eingesetzt werden, da Störungen in benachbarten Kanälen auftreten können.

Praktische Erfahrungen beim digitalen Betrieb mit diesen Verstärkern haben gezeigt, dass insbesondere der Gleichanteil des Amplitudensignals einen sehr großen Einfluss auf den Pegel der Randaussendungen hat. Der gesamte Signalverarbeitungszweig, vom Ausgang des digitalen Modulators bis zur Verstärkerendstufe, muss durchlässig für die Gleichkomponente des Amplitudensignals sein.

Das Amplitudensignal weist nach der Umwandlung von kartesischen in polare Koordinaten einen bei 0 beginnenden, positiven Wertebereich auf. Die Leistungsverstärker im Rundfunkbereich fordern in der Regel zur Ansteuerung ein Amplitudensignal, das symmetrisch zu 0 bzw. 0V liegt. Das bedeutet, dass eine Ansteuerung mit einem Amplitudensignal von 0V bei diesen Sendern bereits zu einer Ausgangsleistung von etwa 25% der Spitzenleistung führt. Um das zu vermeiden, wird dem Amplitudensignal ein negativer Signalpegel zugefügt, der den Gleichanteil so korrigiert, dass bei einem Amplitudensignal von 0V die Ausgangsleistung des Senders ebenfalls 0 ist.

Nach dem Stand der Technik wird der Pegel des Gleichanteils, der dem Amplitudensignal überlagert werden muss, mit spezieller Messtechnik (Oszilloskop, Spektrumanalysator) und speziellen Messsignalen ermittelt und dann manuell an der Gleichanteilskorrektur eingestellt. Bei der Einstellung des Gleichanteils wird beobachtet, welche Auswirkungen die Korrektur auf die Randaussendungen hat. Es kommt hierbei auf eine äußerst exakte Einstellung an, da schon minimale Fehler zu Verzerrungen und damit zu einem starken Anstieg der Randaussendungen führen.

Beschreibungen in der Literatur sind zu diesem Verfahren nicht bekannt, aber in der Praxis wird es vielfach angewendet. Problematisch ist es, den Gleichanteil aufgrund des komplizierten Messverfahrens exakt einzustellen und vor allem zu gewährleisten, dass der eingestellte Pegel über einen längeren Zeitraum den Bedingungen für eine optimale Ansteuerung entspricht. Beispielsweise können temperaturabhängige Schwankungen der Parameter der verwendeten Bauelemente zur Verschiebung der Arbeitspunkte führen und dadurch Veränderungen des Gleichanteils im Amplitudensignal hervorgerufen werden. Deshalb ist im realen Betrieb eine regelmäßige Kontrolle und Korrektur des eingestellten Gleichanteils erforderlich. Das manuelle Mess- und Einstellverfahren ist aber in seiner Präzision begrenzt.

Mit der vorliegenden Erfindung wird für Leistungsverstärker, die zur Übertragung digitaler Modulationssignale das EER-Prinzip anwenden, ein Verfahren vorgeschlagen, mit dem Verzerrungen und damit erhöhte Randaussendungen, die durch Gleichanteilsfehler des Amplitudensignals entstehen, vermieden wenden können.

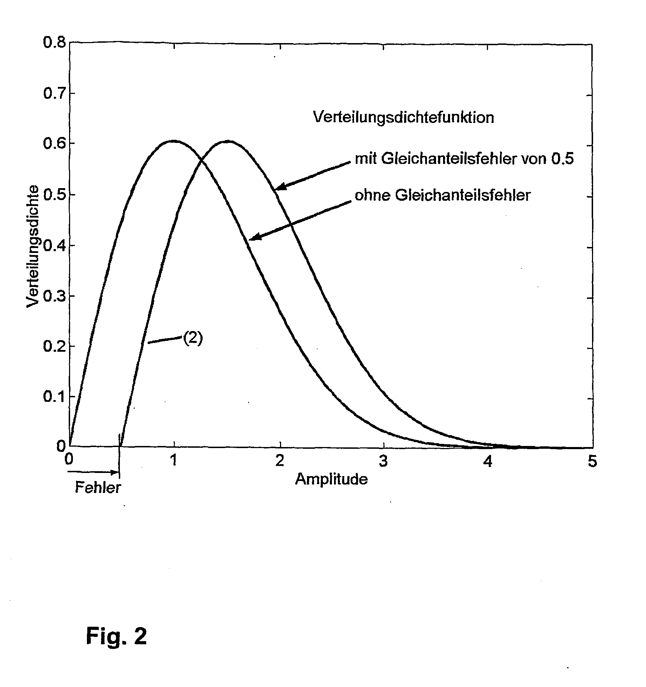

Das Verfahren ermöglicht eine optimale Ansteuerung des Leistungsverstärkers dadurch, dass Gleichanteilsfehler des Amplitudensignals automatisch erfasst und korrigiert werden. Durch ein Modul wird der Gleichanteil des Amplitudensignals rechentechnisch überwacht Bei auftretenden Abweichungen erfolgt automatisch eine Korrektur des Gleichanteils durch Überlagerung des Amplitudensignals mit dem exakten, aber bezüglich des Vorzeichens umgekehrten Pegelwert des Gleichanteilsfehlers.
Für die Bestimmung des Gleichanteilsfehlers wird das Amplitudensignal verwendet, das durch Amplitudendemodulation aus dem Sendesignal abgeleitet werden kann (1). Das Amplitudensignal As wird einem Modul zugeführt, das für die Ermittlung des Gleichanteilsfehlers (E) die Verteilungsdichtefunktion des Amplitudensignals verwendet. Es ist bekannt, dass die Verteilungsdichtefunktion der Amplitudenwerte eines digitalen Modulationssignals einer Rayleigh-Funktion entspricht (Fig.2), wenn die Verteilungsdichte über einen ausreichend großen zeitlichen Signalausschnitt ermittelt wird und folgende Bedingungen erfüllt sind:
- Die Energie des komplexen Modulationssignals ist innerhalb der genutzten Bandbreite annähernd gleichmäßig verteilt.
- Die Spektrale Leistungsdichte des komplexen Modulationssignals weist eine annähernd rechteckige Form auf.

Diese Bedingungen sind bei digitalen Modulationssignalen in der Regel erfüllt.

Wie in Fig.2 dargestellt, beginnt die Rayleigh-Funktion bei sehr kleinen Amplituden mit einem Wert annähernd 0 und steigt dann mit zunehmender Amplitude bis zu einem Maximum an. Danach fällt die Funktion wieder ab und nähert sich dem Wert 0 an. Wenn kein Gleichanteilsfehler vorliegt, beginnt die Verteilungsdichtefunktion des gemessenen Signals As bei kleinen Amplituden mit 0 und steigt dann gleichmäßig an. Liegt ein Gleichanteilsfehler vor, verschiebt sich der Startpunkt der Verteilungsdichtefunktion entlang der Abszisse. Die Form der Rayleigh-Funktion bleibt aber erhalten. Somit kann aus dem Startpunkt der Verteilungsdichtefunktion direkt der Gleichanteilsfehler bestimmt werden.

Bei einem positiven Gleichanteilsfehler des Amplitudensignals verschiebt sich der Startpunkt der Verteilungsdichtefunktion hin zu positiven Werten auf der Abszisse. Der Gleichanteilsfehler entspricht dabei genau der Verschiebung des Startwertes der Rayleigh-Funktion auf der Abszisse (2).

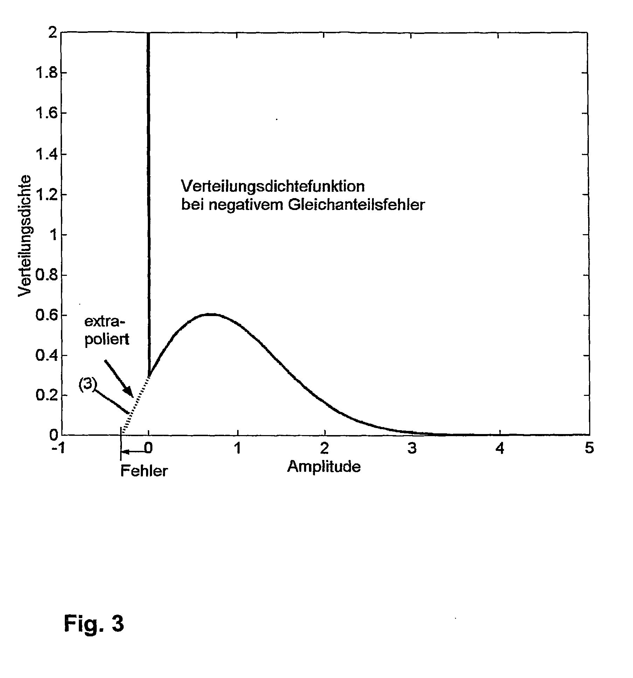

Bei einem negativen Gleichanteilsfehler des Amplitudensignals wird der Verstärker zu niedrig ausgesteuert. Da der Verstärker keine negativen Amplituden verarbeiten kann, werden diese Signale auf einen Minimalwert begrenzt. Die Leistung am Ausgang des Verstärkers ist in diesen Fällen 0. Die Verteilungsdichtefunktion des Amplitudensignals am Verstärkerausgang verschiebt sich in negative Richtung. Durch die Begrenzung des Verstärkers steigt die Verteilungsdichtefunktion an der Stelle 0 stark an (Fig. 3). Alle Signalanteile, die eigentlich im negativen Amplitudenbereich liegen, werden beim Wert 0 aufsummiert. Der im positiven Bereich liegende Teil der Verteilungsdichtefunktion weist immer noch die Form einer Rayleigh-Funktion auf. Da diese Form bekannt ist, kann durch Extrapolation in den negativen Bereich hinein der Schnittpunkt mit der Abszisse und damit der Gleichanteilsfehler bestimmt werden (3).

### Liste der verwendeten Bezugszeichen

- I, Q: Inphase-, Quadraturphasekomponente
- A: Amplitudensignal
- P: Phasensignal
- RF: Radio Frequency (Hochfrequenzträger)
- RF-P: phasenmoduliertes RF-Signal
- Ak: Amplitudensignal mit korrigierten Gleichanteil
- S: Sendesignal
- As: Amplitudensignal aus dem Sendesignal abgeleitet
- E: Gleichanteilsfehler

## Patentansprüche

1. Verfahren für die Ansteuerung von Leistungsverstärkern für digitale Übertragung, bei denen das komplexe digitale Modulationssignal nach dem EER-Prinzip in ein erstes Amplitudensignal (A) und ein phasenmoduliertes Trägersignal (P) umgesetzt wird und beide Signale in einer Senderendstufe zum Sendesignal (S) vereinigt werden, wobei das erste Amplitudensignal vor der Ansteuerung der Senderendstufe in seinem Gleichanteil korrigiert wird,
**dadurch gekennzeichnet, dass** die Korrektur des Gleichanteilsfehlers des ersten Amplitudensignals automatisch erfolgt, indem
a.) aus dem Sendesignal durch Amplitudendemodulation ein zweites Amplitudensignal (As) abgeleitet wird (1),
b.) das zweite Amplitudensignal einem zur Bestimmung des Gleichanteilsfehlers (E) ausgebildeten Modul zugeführt wird,
c.) das Modul zu dem zweiten Amplitudensignal die Verteilungsdichte als Funktion der Amplitude bestimmt,
d.) das Modul den Gleichanteilsfehler des ersten Amplitudensignals als die Verschiebung ermittelt, um welche sich die zuvor für das zweite Amplitudensignal bestimmte Verteilungsdichtefunktion gegenüber einer sich für dieses zweite Amplitudensignal bei einem komplexen Modulationssignal mit innerhalb der genutzten Bandbreite annähernd gleichverteilter Energie und nahezu rechteckförmiger Leistungsdichte ergebenden Rayleigh-Funktion auf der Abszisse verschiebt,
e.) dem ersten Amplitudensignal ein Signal mit dem Pegel des hinsichtlich seines Vorzeichens umgekehrten Gleichanteilsfehlers überlagert wird.

2. Verfahren nach Anspruch 1, **dadurch gekennzeichnet, dass** die Verschiebung der Verteilungsdichtefunktion gegenüber der Rayleigh-Funktion bei einem negativen Gleichanteilsfehler im Hinblick auf die durch den Verstärker gegebene Begrenzung durch Extrapolation ihres Schnittpunkts mit der negativen Abszisse (3) bestimmt wird.

## Claims

1. Method for driving power amplifiers for digital transmission, in which the complex digital modulating signal is converted into a first amplitude signal
(A) and a phase-modulated carrier signal (P) by the EER method and the two signals are combined into the transmit signal (S) in a transmitter final stage, wherein the first amplitude signal has its DC component corrected before the driving of the transmitter final stage,
**characterized in that** the correction of the DC component error of the first amplitude signal takes place automatically **in that**
a.) a second amplitude signal (As) is derived (1) from the transmit signal by amplitude modulation,
b.) the second amplitude signal is delivered to a module designed to determine the DC component error (E),
c.) the module determines the spectral density for the second amplitude signal as a function of amplitude,
d.) the module determines the DC component error of the first amplitude signal as the displacement by which the spectral density function previously determined for the second amplitude signal shifts along the abscissa as compared to a Rayleigh function that results for this second amplitude signal in the case of a complex modulating signal with energy distributed approximately uniformly within the bandwidth used and with nearly rectangular power density,
e.) a signal with the level of its DC component error reversed in terms of its arithmetic sign is superimposed on the first amplitude signal.

2. Method according to claim 1, **characterized in that**, in the case of a negative DC component error relative to the limit set by the amplifier, the displacement of the spectral density function as compared to the Rayleigh function is determined by extrapolating its intersection point with the negative abscissa (3).

## Revendications

1. Procédé de commande d'amplificateurs de puissance pour la transmission numérique dans lesquels le signal de modulation numérique complexe est converti en un premier signal d'amplitude (A) et en un signal porteur modulé en phase (P) selon le principe EER et les deux signaux sont réunis pour former le signal d'émission (S) dans un amplificateur d'émission, le premier signal d'amplitude étant corrigé quant à sa composante continue avant la commande de l'amplificateur d'émission,
**caractérisé en ce que** la correction de l'erreur de composante continue du premier signal d'amplitude s'effectue automatiquement par le fait
a.) qu'un deuxième signal d'amplitude (A) est dérivé du signal d'émission par démodulation d'amplitude (1),
b.) que le deuxième signal d'amplitude est envoyé à un module destiné à déterminer l'erreur de composante continue (E),
c.) que le module détermine la densité de probabilité comme fonction de l'amplitude pour le deuxième signal d'amplitude,
d.) que le module détermine l'erreur de composante continue du premier signal d'amplitude comme degré de déplacement sur l'abscisse de la fonction de densité de probabilité déterminée préalablement pour le deuxième signal d'amplitude par rapport à une fonction de Rayleigh que l'on obtient pour ce deuxième signal d'amplitude dans le cas d'un signal de modulation complexe avec une répartition de l'énergie approximativement uniforme à l'intérieur de la largeur de bande utilisée et une densité de puissance approximativement de forme rectangulaire,
e.) qu'un signal est superposé au premier signal d'amplitude au niveau de l'erreur de composante continue inversée en signe.

2. Procédé selon la revendication 1, **caractérisé en ce que** dans le cas d'une erreur de composante continue négative, le déplacement de la fonction de densité de probabilité par rapport à la fonction de Rayleigh est déterminé par extrapolation de son intersection avec l'abscisse négative (3) compte tenu de la limitation imposée par l'amplificateur.
